(19)

Europäisches
Patentamt
European
Patent Office
Office européen
des brevets

(11) **EP 4 269 103 A1**

(12) **EUROPEAN PATENT APPLICATION**
published in accordance with Art. 153(4) EPC

(43) Date of publication:
**01.11.2023 Bulletin 2023/44**

(21) Application number: **21910034.4**

(22) Date of filing: **12.11.2021**

(51) International Patent Classification (IPC):
*B32B 27/30* (2006.01)    *C08F 290/00* (2006.01)
*C09J 4/02* (2006.01)    *C09J 11/06* (2006.01)
*C09J 175/14* (2006.01)    *C08F 2/38* (2006.01)
*C08F 2/44* (2006.01)    *C08F 2/50* (2006.01)
*H01L 21/304* (2006.01)    *C09J 7/22* (2018.01)
*C09J 7/38* (2018.01)

(52) Cooperative Patent Classification (CPC):
**B32B 27/30; C08F 2/38; C08F 2/44; C08F 2/50;
C08F 290/00; C09J 4/00; C09J 7/22; C09J 7/38;
C09J 11/06; C09J 175/14; H01L 21/304**

(86) International application number:
**PCT/JP2021/041725**

(87) International publication number:
**WO 2022/137881 (30.06.2022 Gazette 2022/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.12.2020 JP 2020213953**

(71) Applicant: **Denka Company Limited
Tokyo 103-8338 (JP)**

(72) Inventors:
• **KIMOTO, Yuki**
**Tokyo 103-8338 (JP)**
• **HAYASHI, Yasunori**
**Tokyo 103-8338 (JP)**
• **HASUMI, Mizuki**
**Tokyo 103-8338 (JP)**

(74) Representative: **Zacco Sweden AB
P.O. Box 5581
Löjtnantsgatan 21
114 85 Stockholm (SE)**

(54) **ULTRAVIOLET-CURABLE RESIN COMPOSITION**

(57) An ultraviolet curable resin composition having:
a monomer and/or an oligomer having a polymerizable
unsaturated double bond; a photopolymerization initiator; a polymerization inhibitor; and an acid having an acid
dissociation constant (pKa1) in pure water of 4.0 or less.

**EP 4 269 103 A1**

Figure 1

Contacting Step

Lamination step

Curing step

Grinding step

**Description**

Technical Field

The present invention relates to an ultraviolet curable resin composition, a cured product of the ultraviolet curable resin composition, a laminate, and a method for producing a semiconductor wafer.

Background Art

In the backgrinding step of grinding a silicon wafer in the semiconductor production step, a pressure-sensitive adhesive film (backgrinding tape) is attached to the circuit surface of a wafer in order to fix the wafer or prevent damage to an electronic part.

As such a pressure-sensitive adhesive film, a pressure-sensitive adhesive film in which a layer coming into contact with a wafer is laminated on a base material film is generally used.

In recent years, the size of a bump formed on the circuit surface has increased, and a conventional pressure-sensitive adhesive film may not be able to absorb a roughness derived from a bump. Therefore, in order to impart a roughness absorbing property to a pressure-sensitive adhesive film, a pressure-sensitive adhesive film in which a roughness absorbing resin layer is provided between a base material film and a layer coming into contact with a wafer is used (see, for example, Patent Literatures 1 and 2).

However, even the backgrinding tape in which a roughness absorbing layer is provided as described above is not different from the conventional pressure-sensitive adhesive film in that it has a film shape, and thus the backgrinding tape has a limited roughness absorption. Because of this, when such a backgrinding tape is used to backgrind a wafer having a particularly large bump, grinding unevenness during the wafer grinding may occur.

Citation List

Patent Literature

Patent Literature 1: Japanese Patent Laid-Open No. 2019-065168

Patent Literature 2: Japanese Patent Laid-Open No. 2019-065165

Summary of Invention

Technical Problem

In order to solve such a problem, the present inventors have studied a backgrinding tape having a new structure using an ultraviolet curable liquid resin composition instead of a pressure-sensitive adhesive film having a roughness absorbing layer formed in advance.

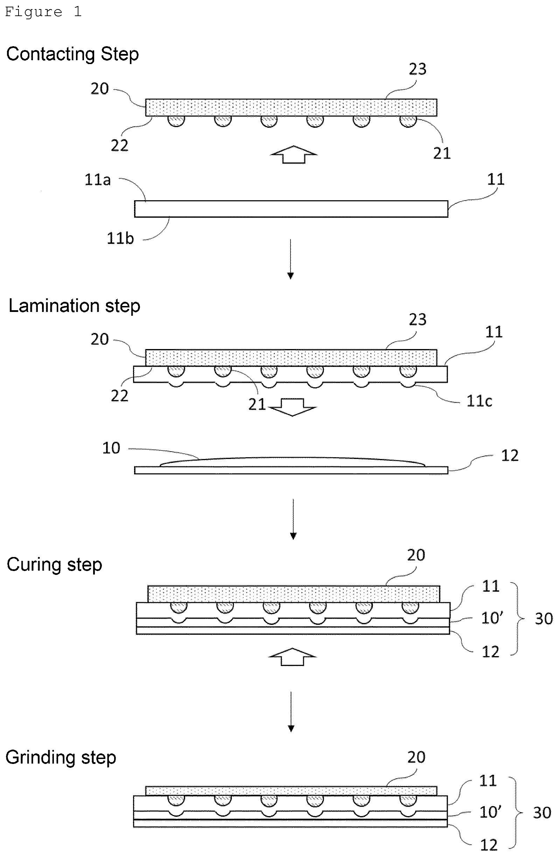

For example, as shown in Figure 1, the backgrinding tape is configured by affixing a surface 11a of an adherend 11 to a front surface 22 of a semiconductor wafer 20, laminating the adherend 11 and a base material 12 with a liquid resin composition 10 therebetween, and curing the liquid resin composition 10. Thereby, even when the semiconductor wafer 20 has a large bump (protruding portion 21), the liquid resin composition 10 can conform to a protruding portion 11c generated on a surface 11b of the adherend 11 to absorb the roughness.

Such a liquid resin composition 10 is required to be able to be stored in a liquid state for a long period of time until it is used, and to exhibit adhesion force to the adherend 11 and the base material 12 when it is cured. However, according to a study by the present inventors, it has been found that the ultraviolet curable liquid resin composition has low storage stability during the storage because it includes a photopolymerization initiator, and may cause unintended curing depending on the state of storage such as exposure to leaked light, the high temperature during the storage, or no exposure to oxygen that serves as a radical trap.

In order to suppress this phenomenon, separate addition of a polymerization inhibitor to the resin composition is conceivable. The polymerization inhibitor suppresses a polymerization reaction by reacting with a radical generated from a photopolymerization initiator or the like and transforming the radical into a stable substance, and thus can prevent the phenomenon of unintended polymerization due to a small amount of a radical generated by light, heat, or the like during the storage.

However, depending on how this polymerization inhibitor is added, there are the following drawbacks: the resin composition may not be sufficiently cured when it is desired to be cured, the adhesion force may be insufficient, or the ultraviolet irradiance or irradiation dose required to obtain sufficient adhesion force may be very large.

The present invention has been made in view of the above problems, and an object thereof is to provide an ultraviolet curable resin composition having excellent initial adhesion force, adhesion force after long-term storage, and storage stability, and a cured product, a laminate, and a method for producing a semiconductor wafer that use the composition.

Solution to Problem

The present inventors have made a diligent study in order to solve the above problems. As a result, the present inventors have found that the above problems can be solved by using a polymerization inhibitor and a predetermined acid in an ultraviolet curable resin composition, and have completed the present invention.

That is, the present invention is as follows.

[1] An ultraviolet curable resin composition comprising: a monomer and/or an oligomer having a polymerizable unsaturated double bond;

a photopolymerization initiator;
a polymerization inhibitor; and
an acid having an acid dissociation constant (pKa1) in pure water of 4.0 or less.

[2] The ultraviolet curable resin composition according to [1], wherein
an absolute value difference between a solubility parameter of the polymerization inhibitor and a solubility parameter of all of the monomer in the resin composition is 4.0 $(cal/cm^3)^{1/2}$ or less.

[3] The ultraviolet curable resin composition according to [1] or [2], wherein
a content of the polymerization inhibitor is 0.02 to 2.0% by weight based on the total weight of the ultraviolet curable resin composition.

[4] The ultraviolet curable resin composition according to any one of [1] to [3], wherein
a content of the acid is 0.005 to 2.0% by weight based on the total weight of the ultraviolet curable resin composition.

[5] The ultraviolet curable resin composition according to any one of [1] to [4], wherein
the polymerization inhibitor comprises an amine-based polymerization inhibitor.

[6] The ultraviolet curable resin composition according to any one of [1] to [5], wherein
the photopolymerization initiator comprises a radical generating photopolymerization initiator and/or an anion generating photopolymerization initiator.

[7] The ultraviolet curable resin composition according to any one of [1] to [6], wherein
the oligomer comprises a urethane acrylate oligomer.

[8] The ultraviolet curable resin composition according to any one of [1] to [7], wherein
the monomer comprises a monofunctional acrylamide.

[9] The ultraviolet curable resin composition according to [8], wherein
a surface tension of the monofunctional acrylamide is 30 to 38 mN/m.

[10] The ultraviolet curable resin composition according to any one of [1] to [9], wherein
a viscosity thereof at 25°C is 200 to 10000 mPa·s.

[11] A cured product obtained by curing the ultraviolet curable resin composition according to any one of [1] to with an ultraviolet ray.

[12] A laminate obtained by adhering a base material having an ultraviolet transmission property and an adherend with the ultraviolet curable resin composition according to any one of [1] to [10] therebetween by curing thereof.

[13] The laminate according to [12], wherein
the laminate is for use in a semiconductor processing application.

[14] A method for producing a semiconductor wafer, comprising:

an affixing step of affixing an adherend to a surface of a semiconductor wafer on which a protruding portion is provided;
a lamination step of laminating the adherend and a base material having an ultraviolet transmission property with the ultraviolet curable resin composition according to any one of [1] to [10] therebetween;
a curing step of curing the ultraviolet curable resin composition by irradiation with an ultraviolet ray from a side facing toward the base material; and
a grinding step of grinding a surface of the semiconductor wafer opposite to the surface on which the protruding portion is provided.

Advantageous Effects of Invention

According to the present invention, it is possible to provide an ultraviolet curable resin composition having excellent initial adhesion force, adhesion force after long-term storage, and storage stability, and a cured product, a laminate, and a method for producing a semiconductor wafer that use the composition.

Brief Description of Drawing

[Figure 1] Figure 1 is a diagram showing an example of a backgrinding step of a semiconductor wafer using the resin composition of the present embodiment.

Description of Embodiment

Hereinafter, an embodiment of the present invention (hereinafter, referred to as "the present embodiment") will be described in detail, but the present invention is not limited thereto, and various modifications can be made as long as these do not depart from the scope of the present invention. In the drawing, the same elements are designated by the same reference signs, and a duplicate description will be omitted. In addition, a positional relationship such as up, down, left, and right shall be based on the positional relationship shown in the drawing unless otherwise specified. Further, a dimensional ratio in the drawing is not limited to the ratio shown.

[Ultraviolet curable resin composition]

The ultraviolet curable resin composition of the present embodiment (hereinafter, also simply referred to as the "resin composition") includes a monomer having a polymerizable unsaturated double bond and/or an oligomer having a polymerizable unsaturated double bond, a photopolymerization initiator, a polymerization inhibitor, and an acid having an acid dissociation constant (pKa1) in pure water of 4.0 or less (hereinafter, also simply referred to as an "acid"), and if necessary, may include a tackifier or a further additive. The monomer and oligomer are collectively also referred to as a polymerizable compound.

First, an example of a mode of use of the resin composition of the present embodiment will be briefly described. An example of a backgrinding step of a semiconductor wafer using the resin composition of the present embodiment is shown in Figure 1. In Figure 1, a semiconductor wafer 20 has a protruding portion 21 on a front surface 22.

First, the front surface 22 of the semiconductor wafer 20 and a surface 11a of an adherend 11 are affixed to protect the protruding portion 21 (affixing step). At this time, a protruding portion 11c as if the protruding portion 21 were transferred, corresponding to the protruding portion 21, can be formed on a surface 11b of the adherend 11. Next, in order to absorb the protruding portion 11c, the adherend 11 and a base material 12 are laminated with a liquid resin composition 10 therebetween (lamination step), and the resin composition 10 is cured with irradiation with an ultraviolet ray from the base material 12 side (curing step). A cured resin composition 10' serves as a roughness absorbing layer that absorbs the protruding portion 21 (protruding portion 11c).

Then, a back surface 23 of the semiconductor wafer 20 is ground with a laminate 30 of the adherend 11, the cured resin composition 10', and the base material 12 in close contact with the front surface 22 of the semiconductor wafer 20 (grinding step), and after grinding, the laminate 30 is peeled off.

By absorbing the protruding portion by using the liquid resin composition 10 as described above, the in-plane pressure applied to the semiconductor wafer 20 in the grinding step can be made uniform regardless of the size of the protruding portion 21. Because of this, it is possible to reduce the grinding unevenness derived from the protruding portion 21.

In particular, a backgrinding tape having a roughness absorbing layer as a layer structure in advance as in the conventional case has limited roughness absorbing performance, but according to the present embodiment, the liquid resin composition absorbs a roughness-derived step and is cured, and thus it is possible to configure an appropriate roughness absorbing layer according to the roughness of the semiconductor wafer.

Further, in the present embodiment, by having the above configuration, the adhesion performance between the cured resin composition 10' and both the adherend 11 and the base material 12 can be further improved. Thereby, it is possible to suppress the occurrence of unintended peeling at the interface between the resin composition 10' and the adherend 11 or the interface between the resin composition 10' and the base material 12 when the laminate 30 is peeled off. Because of this, it is possible to suppress, for example, the remaining of a part of the adherend 11 as an adhesive residue on the front surface 22 of the semiconductor wafer 20, for example, a depressed portion other than the protruding portion 21 (bump), due to unintended peeling at the above interface.

Especially, according to a study by the present inventors, it has been found that even if a decrease in adhesion performance as described above is not observed when the resin composition just after preparation is used, the performance of adhesion of the resin composition to the adherend and the base material decreases when the resin composition after storage for a predetermined period of time is used. On the other hand, according to the resin composition of the present embodiment, it is possible to exhibit high adhesion force even after long-term storage, particularly by using a predetermined acid. In addition, the resin composition of the present embodiment is also excellent in terms of the ability to be easily applied (applicability) and curing with a low ultraviolet irradiation dose (curability).

The ultraviolet curable resin composition of the present embodiment can be used not only as a composition used in a semiconductor processing application, for example, a composition used for forming a roughness absorbing layer when a dicing tape for cutting a semiconductor wafer or a semiconductor package or a backgrinding tape is affixed, but also as a resin composition for interlayer adhesion that adheres a plurality of different members. Hereinafter, the configuration of the present embodiment will be described in detail.

[Polymerizable compound]

The resin composition of the present embodiment includes at least one of a monomer having a polymerizable unsaturated double bond and/or an oligomer having a polymerizable unsaturated double bond as a polymerizable compound that can be polymerized by a photopolymerization initiator. Such monomers and such oligomers may each be used singly or in combinations of two or more, and such a monomer and such an oligomer may be used in combination.

(Monomer)

The monomer is not particularly limited as long as it has a polymerizable unsaturated double bond, and examples thereof include an alkene, a vinyl ether, (meth)acrylic acid, a (meth)acrylic acid ester, and a (meth)acrylamide. As used herein, "(meth)acrylate" is a designation that collectively describes acrylate and methacrylate corresponding thereto, and "(meth)acryl" is a designation that collectively describes acryl and methacryl corresponding thereto.

Among these, (meth)acrylic acid, a (meth)acrylic acid ester, and a (meth)acrylamide are preferable, and acrylic acid, an acrylic acid ester, and an acrylamide are more preferable. By using such a monomer, the curability tends to be further improved.

The (meth)acrylic acid ester is not particularly limited, and examples thereof include an alicyclic (meth)acrylic acid ester such as isoamyl (meth)acrylate, stearyl (meth)acrylate, lauryl (meth)acrylate, octyl (meth)acrylate, decyl (meth)acrylate, isodecyl (meth)acrylate, isomyristyl (meth)acrylate, or isostearyl (meth)acrylate; an alicyclic (meth)acrylic acid ester such as isobornyl (meth)acrylate or cyclohexyl acrylate; and an aromatic (meth)acrylic acid ester such as phenoxyethyl (meth)acrylate or benzyl (meth)acrylate.

Among these, an aliphatic (meth)acrylic acid ester and an alicyclic (meth)acrylic acid ester are preferable, and an aliphatic (meth)acrylic acid ester and an alicyclic (meth)acrylic acid ester are more preferably used in combination. By using such a monomer, in addition to the initial adhesion force and the adhesion force after long-term storage, the hardness of the cured product, the applicability, and the curability tend to be further improved.

The surface tension of the (meth)acrylic acid ester is preferably 5 to 40 mN/m, and more preferably 5 to 35 mN/m. When the surface tension of the (meth)acrylic acid ester is within such a range, the applicability tends to be further improved, and the adhesion force after long-term storage and the initial adhesion force tend to be further improved. The surface tension can be measured by a pendant drop method.

The total content of the aliphatic (meth)acrylic acid ester and the alicyclic (meth)acrylic acid ester is preferably 15 to 45% by weight, more preferably 20 to 400 by weight, and further preferably 25 to 35% by weight based on the total weight of the resin composition.

When the content of each of the aliphatic (meth)acrylic acid ester and the alicyclic (meth)acrylic acid ester is within such a range, in addition to the initial adhesion force and the adhesion force after long-term storage, the hardness of the cured product, the applicability, and the curability tend to be further improved.

The (meth)acrylamide is not particularly limited, and examples thereof include (meth)acrylamide, N,N-dimethyl (meth)acrylamide, N,N-diethyl (meth)acrylamide, hydroxyethyl (meth)acrylamide, isopropyl (meth)acrylamide, (meth)acryloylmorpholine, and dimethylaminopropyl (meth)acrylamide.

The resin composition of the present embodiment preferably includes a monofunctional acrylamide as a monomer. By including a monofunctional acrylamide, the compatibility of a photopolymerization initiator, a polymerization inhibitor, an acid, or the like tends to be further improved, the wettability of the resin composition to the adherend tends to be further improved, and the initial adhesion force and the adhesion force after long-term storage tend to be further improved.

The surface tension of the monofunctional acrylamide is preferably 30 to 38 mN/m. When the surface tension of the monofunctional acrylamide is in the above range, the wettability of the resin composition to the adherend tends to be further improved, and the initial adhesion force and the adhesion force after long-term storage tend to be further improved. Examples of the monofunctional acrylamide include dimethylacrylamide (surface tension of 37.12 mN/m) and diethyl acrylamide (surface tension of 33.13 mN/m).

The content of the (meth)acrylamide is preferably 20 to 45% by weight, more preferably 25 to 40% by weight, and further preferably 30 to 35% by weight based on the total weight of the resin composition. When the content of the (meth)acrylamide is within such a range, in addition to the initial adhesion force and the adhesion force after long-term storage, the hardness of the cured product, the applicability, and the curability tend to be further improved.

The number of polymerizable unsaturated double bonds of each of the above monomers is preferably 1 to 3, more preferably 1 to 2, and further preferably 1. By using such a monomer, in addition to the initial adhesion force and the adhesion force after long-term storage, the hardness of the cured product, the applicability, and the curability tend to be further improved.

[Oligomer]

The oligomer is not particularly limited as long as it has a polymerizable unsaturated double bond, and examples thereof include a urethane (meth)acrylate oligomer, an epoxy (meth)acrylate oligomer, and a polyester (meth)acrylate oligomer.

Among these, a urethane (meth)acrylate oligomer is preferable, and a urethane acrylate oligomer is more preferable. By using such an oligomer, the wettability of the resin composition to the base material and the adherend tends to be further improved, and the adhesion force of the cured resin composition to the base material and the adherend tends to be further improved.

The urethane (meth)acrylate oligomer is not particularly limited, and examples thereof include an aromatic urethane acrylate oligomer and an aliphatic urethane acrylate oligomer. Among these, an aliphatic urethane acrylate oligomer is more preferable. By using such an oligomer, in addition to the initial adhesion force and the adhesion force after long-term storage, the storage stability, the hardness of the cured product, the applicability, and the curability tend to be further improved.

The number of polymerizable unsaturated double bonds of such an oligomer is preferably 1 to 10, more preferably 2 to 6, and further preferably 2 to 4. By using such an oligomer, in addition to the initial adhesion force and the adhesion force after long-term storage, the hardness of the cured product, the applicability, and the curability tend to be further improved.

In addition, the weight average molecular weight of the oligomer is preferably 100000 or less, more preferably 5000 to 75000, and further preferably 10000 to 50000. When the weight average molecular weight of the oligomer is within such a range, the viscosity of the resin composition is suppressed to a lower level, and the applicability tends to be further improved.

The content of the oligomer is preferably 12.5 to 37.5% by weight, more preferably 17.5 to 32.5% by weight, and further preferably 22.5 to 27.5% by weight based on the total weight of the resin composition. When the content of the oligomer is within such a range, in addition to the initial adhesion force and the adhesion force after long-term storage, the hardness of the cured product, the applicability, and the curability tend to be further improved.

[Polymerization inhibitor]

A polymerization inhibitor is added to the resin composition of the present invention. By adding a polymerization inhibitor, it is possible to suppress an unintended curing reaction due to heat or the like between the polymerizable compound and the photopolymerization initiator, and improve the storage stability.

The polymerization inhibitor is not particularly limited, and examples thereof include a phenol-based polymerization inhibitor, a quinone-based polymerization inhibitor, an amine-based polymerization inhibitor, a nitroso-based polymerization inhibitor, and a transition metal-based polymerization inhibitor.

Such a polymerization inhibitor is not particularly limited, and examples thereof include methylhydroquinone, hydroquinone, 2,2-methylene-bis(4-methyl-6-tertiary butylphenol), catechol, hydroquinone monomethyl ether, monotertiary butylhydroquinone, 2,5-ditertiary butylhydroquinone, p-benzoquinone, 2,5-diphenyl-p-benzoquinone, 2,5-ditertiary butyl-p-benzoquinone, 2,5-dichloro-p-benzoquinone, 2,6-dichloro-p-benzoquinone, picric acid, tertiary butylcatechol, 2-butyl-4-hydroxyanisole and 2,6-ditertiary butyl-p-cresol, p-nitrosodiphenylamine, p-nitrosodimethylaniline, phenothiazine, 3,7-dioctylphenothiazine, 3,7-dicumylphenothiazine, diphenylamine, 4-oxydiphenylamine, N,N-diethylhydroxylamine, N,N-di-2-naphthyl-1,4-phenylenediamine, 2,2,6,6-tetramethylpiperidinyl-1-oxyl, 4-hydroxy-2,2,6,6-tetramethylpiperidinyl-1-oxyl, cupferron, copper(II) chloride, and iron(III) chloride.

Among these, an amine-based polymerization inhibitor is more preferable. By using an amine-based polymerization inhibitor, the storage stability, the initial adhesion force, and the adhesion force after long-term storage tend to be further improved. The amine-based polymerization inhibitor is not particularly limited, and examples thereof include phenothiazine ($\delta$ = 12.3), 3,7-dioctylphenothiazine ($\delta$ = 9.0), 3,7-dicumylphenothiazine ($\delta$ = 11.1), diphenylamine ($\delta$ = 10.8), 4-oxydiphenylamine ($\delta$ = 12.6), and N,N-diethylhydroxylamine ($\delta$ = 11.3). The $\delta$ in parentheses indicates the solubility parameter (SP value) of each compound.

As the polymerization inhibitor, one having an absolute value difference from the solubility parameter (SP value) of all of the monomer having a polymerizable unsaturated double bond included in the resin composition of 4.0 $(cm^3/mol)^{1/2}$ or less is preferable. By setting the absolute value difference in the SP value to 4.0 or less, the compatibility with the resin composition is improved, improvement in the polymerization suppressing ability and the prevention of the precipitation of the polymerization inhibitor during the low temperature storage can be expected.

The SP value $\delta$ of each of the monomers and the inhibitor was calculated by the Fedors method shown below. First, the structural formula of the polymerization inhibitor is divided into a structure such as a characteristic group such as a methyl group, an ethyl group, or a phenyl group, or a functional group such as a hydroxyl group or an amino group. The solubility parameter may be calculated by the following expression (1) by using the summation $\Sigma Ei$ of the heat of vaporization factor Ei (cal/mol) and the summation $\Sigma Vi$ of the molar volume factor Vi $(cm^3/mol)$ determined for each structure.

$$\delta[(MPa)^{1/2}] = [\Sigma Ei/\Sigma Vi]^{1/2} \quad (1)$$

Details of this method are disclosed in R.F. Fedors, Polymer Engineering & Science, Vol. 14, P147-154 (Wiley Publishing, 1974) or the like. The SP value of all of the monomer is a value obtained by averaging the SP value of each monomer alone determined by the above method based on the mole fractions of constituent monomers in all of the monomer.

The content of the polymerization inhibitor is preferably 0.02 to 2.0% by weight, more preferably 0.05 to 1.0% by weight, and further preferably 0.1 to 0.6% by weight based on the total weight of the resin composition. When the content of the polymerization inhibitor is 0.02% by weight or more, the unintended reaction between the polymerizable compound and the photopolymerization initiator can be sufficiently suppressed, and the storage stability tends to be further improved. When the content of the polymerization inhibitor is 2.0% by weight or less, instead the polymerization inhibitor tends to inhibit the curing reaction, and a decrease in the hardness and the adhesion force of the cured product tends to be suppressed. In addition, when the content of the polymerization inhibitor is 2.0% by weight or less, the precipitation of the polymerization inhibitor tends to be further suppressed during the low temperature storage.

[Acid]

The resin composition of the present embodiment includes an acid having a first stage acid dissociation constant (pKa1) in pure water of 4.0 or less. By using such an acid, sufficient adhesion force can be obtained with an ultraviolet ray having a low irradiance and a low irradiation dose even when a polymerization inhibitor is included. As the acid dissociation constant, a value disclosed in the Handbook of Chemistry, Maruzen Publishing Co., Ltd. can be adopted.

In the present embodiment, the reason why the adhesion force is exhibited by an acid is not particularly limited, and for example, it is considered that when the resin composition is cured, the acid penetrates the base material and/or the adherend to induce an electrostatic interaction at the interface between the resin composition and the base material and/or the adherend, and additionally the resin composition is cured in a state of partial penetration of the acid into the adherend and the acid develops an anchor effect to enhance the adhesion force.

As the acid, any acid including a divalent or higher acid can be used as long as the first step acid dissociation constant (pKa1) in pure water is 4.0 or less. Such an acid is not particularly limited, and examples thereof include an inorganic acid such as hydrochloric acid, sulfuric acid, nitric acid, or phosphoric acid; and an organic acid such as formic acid, chloroacetic acid, dichloroacetic acid, trichloroacetic acid, fluoroacetic acid, bromoacetic acid, iodoacetic acid, 2-(trifluoromethyl)acrylic acid, picolinic acid, oxalic acid, malonic acid, phthalic acid, isophthalic acid, terephthalic acid, citric acid, trimesic acid, trimellitic acid, pyromellitic acid, ethylenediaminetetraacetic acid, maleic acid, fumaric acid, or muconic acid.

Among these, an acid having a lower pKa1 more easily penetrates the base material and the adherend and can be expected to have the effect of improving the adhesion force, and thus the pKa1 is more preferably 3.2 or less. Examples of such an acid include hydrochloric acid, sulfuric acid, nitric acid, phosphoric acid, chloroacetic acid, dichloroacetic acid, trichloroacetic acid, fluoroacetic acid, bromoacetic acid, iodoacetic acid, 2-(trifluoromethyl)acrylic acid, picolinic acid, oxalic acid, phthalic acid, citric acid, trimesic acid, trimellitic acid, pyromellitic acid, ethylenediaminetetraacetic acid, maleic acid, and fumaric acid. In addition, from the viewpoint of compatibility with the polymerizable compound, the acid is preferably an organic acid.

The first stage acid dissociation constant (pKa1) in pure water of the acid is 4.0 or less, preferably 3.2 or less, more preferably -10 to 3.2, and further preferably -2 to 3.2, and particularly preferably 0 to 3.2. When the acid dissociation constant (pKa1) of the acid is 4.0 or less, the effect of improving the adhesion force by the acid is further improved. In addition, when the acid dissociation constant (pKa1) of the acid is -10 or more, it is possible to suppress the modification of another component such as the polymerizable compound of the resin composition, the adherend, or the base material by the acid, or the erosion of a member of an apparatus feeding the resin composition by the acid.

The acid desirably has no polymerizable unsaturated double bond. Thereby, it is possible to avoid the incorporation of the acid into the polymerization of the polymerizable compound, and it is possible to suppress the decrease in the amount of the acid that penetrates the base material or the adherend. Because of this, the effect of improving the adhesion force by the acid tends to be more preferably exhibited.

The content of the acid is preferably 0.005 to 2.0% by weight, more preferably 0.01 to 1.0% by weight, and further preferably 0.015 to 0.5% by weight based on the total weight of the resin composition. When the content of the acid is 0.005% by weight or more, the effect of improving the adhesion force by the acid tends to be further improved. In addition, when the content of the acid is 2.0% by weight or less, the risk of corrosion of a metal pipe during the storage in the metal pipe is reduced, and the separation or precipitation of the acid that has become incompatible during the long-term storage tends to be suppressed.

[Photopolymerization initiator]

The photopolymerization initiator is not particularly limited as long as it generates a radical or an anion by irradiation with visible light or an ultraviolet ray, and examples thereof include a radical generating photopolymerization initiator and/or an anion generating photopolymerization initiator. Among these, a radical generating photopolymerization initiator is preferable. By using such a photopolymerization initiator, the polymerization rate is further improved and the resin composition can be cured quickly.

The radical generating photopolymerization initiator is not particularly limited, and examples thereof include benzophenone and a derivative thereof; benzyl and a derivative thereof; antraquinone and a derivative thereof; a benzoin derivative such as benzoin, benzoin methyl ether, benzoin ethyl ether, benzoin propyl ether, benzoin isobutyl ether, or benzyl dimethyl ketal; an acetophenone derivative such as diethoxyacetophenone or 4-t-butyltrichloroacetophenone; 2-dimethylaminoethylbenzoate, p-dimethylaminoethylbenzoate, diphenyldisulfide, thioxanthone, and derivatives thereof; a camphorquinone derivative such as camphorquinone, 7,7-dimethyl-2,3-dioxobicyclo[2.2.1]heptane-1-carboxylic acid, 7,7-dimethyl-2,3-dioxobicyclo[2.2.1]heptane-1-carboxy-2-bromoethyl ester, 7,7-dimethyl-2,3-dioxobicyclo[2.2.1]heptane-1-carboxy-2-methyl ester, or 7,7-dimethyl-2,3-dioxobicyclo[2.2.1]heptane-1-carboxylic acid chloride; an $\alpha$-aminoalkylphenone derivative such as 2-methyl-1-[4-(methylthio)phenyl]-2-morpholinopropan-1-one or 2-benzyl-2-dimethylamino-1-(4-morpholinophenyl)-butanone-1; an acylphosphine oxide derivative such as benzoyldiphenylphosphine oxide, 2,4,6-trimethylbenzoyldiphenylphosphine oxide, benzoyldiethoxyphosphine oxide, 2,4,6-trimethylbenzoyldimethoxyphenylphosphine oxide, or 2,4,6-trimethylbenzoyldiethoxyphenylphosphine oxide; and an oxyphenylacetic acid ester derivative such as oxy-phenyl-acetic acid 2-[2-oxo-2-phenyl-acetoxy-ethoxy]-ethyl ester or oxy-phenyl-acetic acid 2-[2-hydroxy-ethoxy]-ethyl ester.

Among these, a benzoin derivative, an acylphosphine oxide derivative, and an oxyphenylacetic acid ester derivative are preferable, and benzyl dimethyl ketal, 2,4,6-trimethylbenzoyldiphenylphosphine oxide, oxy-phenyl-acetic acid 2-[2-oxo-2-phenyl-acetoxy-ethoxy]-ethyl ester, and oxy-phenyl-acetic acid 2-[2-hydroxy-ethoxy]-ethyl ester are more preferable, in terms of excellent curability.

The content of the photopolymerization initiator is preferably 0.01 to 10.0% by weight, more preferably 0.1 to 5.0% by weight, and further preferably 0.2 to 3.0% by weight based on the total weight of the resin composition. When the content of the photopolymerization initiator is 0.01% by weight or more, the curing reaction proceeds favorably, and the hardness and the adhesion force of the cured product tend to be further improved. In addition, when the content of the photopolymerization initiator is 10.0% by weight or less, the storage stability of the resin composition tends to be further improved. In addition, when the content of the photopolymerization initiator is 10.0% by weight or less, it tends to be suppressed, that the curing proceeds only on the surface of the resin composition when irradiated with an ultraviolet ray, and the curing does not proceed to the inside, and a decrease in the adhesion force of the cured product.

[Tackifier]

The resin composition of the present embodiment may further include a tackifier. By including a tackifier, the pressure-sensitive adhesiveness of the cured product tends to be further improved.

Such a tackifier is not particularly limited, and examples thereof include a terpene resin, a terpene phenol resin, an alicyclic saturated hydrocarbon resin, a rosin ester, a rosin, a styrene resin, and an aliphatic hydrocarbon resin. Among these, a terpene phenol resin is preferably used.

The terpene resin is not particularly limited, and examples thereof include a homopolymer or a copolymer of a terpene monomer. Examples of the terpene monomer include $\alpha$-pinene, $\beta$-pinene, and limonene, and these may be used singly or in combination.

The terpene phenol resin is not particularly limited, and examples thereof include a terpene phenol resin produced by reacting a terpene compound with a phenol compound by a conventionally known method, and such a terpene phenol resin is not particularly limited, and examples thereof include a terpene phenol resin produced by reacting 1 mol of a terpene compound with 0.1 to 50 mol of a phenol compound by a conventionally known method.

The terpene compound is not particularly limited, and examples thereof include myrcene, allo-ocimene, α-pinene, β-pinene, limonene, α-terpinene, γ-terpinene, camphene, terpinolene, and delta-3-carene. Among these compounds, α-pinene, β-pinene, limonene, myrcene, allo-ocimene, and α-terpinene are preferably used.

The phenol compound is not particularly limited, and examples thereof include, but are not limited to, phenol, cresol, xylenol, catechol, resorcin, hydroquinone, and bisphenol A. The ratio of the phenol compound in the terpene phenol resin is about 25 to 50 molo, but is not limited thereto. The hydroxyl value of the terpene phenol resin is about 50 to 250, but is not limited thereto.

The softening point of the terpene phenol resin is preferably 100°C or more and 180°C or less. Within this range, the peelability, the adhesive remaining property, and the mass change after heating can be suppressed.

The alicyclic saturated hydrocarbon resin is not particularly limited, and examples thereof include a resin obtained by partially or completely hydrogenating an aromatic (C9) petroleum resin.

The rosin is not particularly limited, and examples thereof include a natural rosin such as gum rosin, tall oil rosin, or wood rosin, and a hydrogenated rosin obtained by subjecting a natural rosin to a hydrogenation reaction.

The rosin ester is not particularly limited, and examples thereof include a methyl ester, a triethylene glycol ester, and a glycerin ester of any of the above rosins.

The content of the tackifier resin is preferably 1 to 20% by weight, and more preferably 3 to 15% by weight based on the total weight of the resin composition. When the content of the tackifier is within such a range, the adhesion force tends to be further improved, and the applicability of the resin composition and the hardness tend to be further improved.

[Further additive]

The resin composition of the present embodiment may include a further additive, if necessary. The further additive is not particularly limited, and examples thereof include an additive such as various commonly used elastomers such as acrylic rubber, urethane rubber, an acrylonitrile-butadiene copolymer, or a methyl methacrylate-butadiene-styrene copolymer, a polar organic solvent, an inorganic filler, a reinforcing material, a plasticizer, a thickener, a dye, a pigment, a flame retardant, a silane coupling agent, a surfactant, or a foaming agent.

[Viscosity]

The resin composition of the present embodiment is preferably in a liquid state at room temperature (25°C). The viscosity of the resin composition at 25°C is preferably 200 to 10000 mPa·s, more preferably 250 to 5000 mPa·s, and further preferably 300 to 2500 mPa·s. When the viscosity is 200 mPa·s or more, the flowing out of the resin composition sandwiched between the adherend and the base material before curing is more suppressed, and it tends to be easy to prepare a cured product having a target thickness. When the viscosity is 10,000 mPa·s or less, the fluidity of the resin composition is further improved, and an air bubble tends to be less likely to remain inside a cured product and at the interface between the cured product and the base material or the adherend after ultraviolet curing.

[Method for producing ultraviolet curable resin composition]

The method for producing the ultraviolet curable resin composition of the present embodiment is not particularly limited as long as it is a method involving mixing the above components, and any mixer can be used.

[Cured product]

The cured product of the present embodiment is obtained by curing the above resin composition with an ultraviolet ray. As will be described later, the above resin composition can be used not only as a backgrinding tape used in a method for producing a semiconductor wafer, but also as a resin composition for interlayer adhesion that adheres a plurality of different members.

[Laminate]

The laminate of the present embodiment is obtained by adhering a base material having an ultraviolet transmission property and an adherend with the above resin composition therebetween by curing thereof. Here, the "ultraviolet transmission property" means that the transmittance of an ultraviolet ray having a wavelength of 365 nm is 50% or more.

The base material having an ultraviolet transmission property is not particularly limited, and examples thereof include a base material including a polyolefin such as polyethylene, polypropylene, polymethylpentene, or an ethylene-vinyl acetate copolymer, and a polyolefin-based ionomer, polyethylene terephthalate (PET), polybutylene terephthalate, polyamide, polyether sulfone, or an ionomer resin. The material constituting the adherend is not particularly limited, and examples thereof include a metal, glass, and a resin.

The laminate is preferably used in a semiconductor processing application. In this case, a sheet-shaped resin is preferable as the adherend. Such a resin is not particularly limited, and examples thereof include an ionomer resin, an ethylene-vinyl acetate copolymer, a flexible polypropylene resin, an ethylene-(meth)acrylic acid copolymer resin, an ethylene-butadiene copolymer resin, a hydrogenated resin of an ethylene-butadiene copolymer, an ethylene-1-butene copolymer resin, and a flexible acrylic resin. By using such a resin sheet, the conformability to a bump and the peelability tends to be further improved.

The cured product and the laminate can be prepared by irradiating the ultraviolet curable resin composition with an ultraviolet ray to cause a curing reaction. In particular, in the case of the laminate, the laminate can be prepared by sandwiching the resin composition between the base material and the adherend and irradiating the resin composition with an ultraviolet ray from the direction of the base material having an ultraviolet transmission property.

The irradiation conditions of an ultraviolet ray are not particularly limited. The irradiation energy of an ultraviolet ray is preferably 200 to 10000 mJ/cm$^2$, more preferably 300 to 8000 mJ/cm$^2$, and further preferably 500 to 6000 mJ/cm$^2$. When the irradiation energy is 200 mJ/cm$^2$ or more, the resin composition is sufficiently cured, and the hardness and the adhesion force of the cured product obtained tend to be further improved. In addition, when the irradiation energy is 10000 mJ/cm$^2$ or less, excessive curing shrinkage is suppressed, and a situation in which the adhesion force is instead reduced tends to be avoided.

The ultraviolet irradiance is preferably 15 to 120 mW/cm$^2$, and more preferably 30 to 100 mW/cm$^2$. When the irradiance is 15 mW/cm$^2$ or more, the resin composition is sufficiently cured, and the hardness and the adhesion force of the cured product obtained tend to be further improved. In addition, when the irradiance is 120 mW/cm$^2$ or less, it tends to be suppressed, that the curing proceeds only on the surface of the resin composition when irradiated with an ultraviolet ray, and the curing does not proceed to the inside, and a decrease in the adhesion force of the cured product.

The ultraviolet irradiation source is not particularly limited, and examples thereof include a known ultraviolet irradiation source such as a deuterium lamp, a high pressure mercury lamp, an ultrahigh pressure mercury lamp, a low pressure mercury lamp, a xenon lamp, a xenon-mercury hybrid lamp, a halogen lamp, an excimer lamp, an indium lamp, a thallium lamp, an LED lamp, and an electrodeless discharge lamp. Among these, an LED lamp that can easily adjust the irradiation dose and the irradiation intensity is preferably used.

[Method for producing semiconductor wafer]

The method for producing a semiconductor wafer according to the present embodiment includes an affixing step of affixing an adherend to a surface of a semiconductor wafer on which a protruding portion is provided; a lamination step of laminating the adherend and a base material having an ultraviolet transmission property with the above ultraviolet curable resin composition therebetween; a curing step of curing the ultraviolet curable resin composition by irradiation with an ultraviolet ray from a side facing toward the base material; and a grinding step of grinding a surface of the semiconductor wafer opposite to the surface on which the protruding portion is provided. Hereinafter, the method for producing a semiconductor wafer according to the present embodiment will be described with reference to Figure 1.

(Affixing step)

The affixing step is a step of affixing an adherend 11 to a front surface 22 of a semiconductor wafer 20 on which a protruding portion 21 is provided. The method for affixing the adherend 11 is not particularly limited, and the adherend 11 may be affixed to the front surface 22 of the semiconductor wafer 20 under normal pressure or under reduced pressure. In addition, in the affixing step, the adherend 11 may be affixed to the front surface 22 of the semiconductor wafer 20 with the adherend 11 in a preheated state, or the adherend 11 may be affixed to the front surface 22 of the semiconductor wafer 20 and then heated. At this time, a protruding portion 11c as if the protruding portion 21 were transferred, corresponding to the protruding portion 21, can be formed on a surface 11b of the adherend 11.

(Lamination step)

The lamination step is a step of laminating the adherend 11 and a base material 12 having an ultraviolet transmission property with the above resin composition 10 therebetween. In the lamination step, the space between the adherend 11 and the base material 12 can be filled with the resin composition 10 in an arbitrary shape by laminating the adherend 11 and the base material 12 in such a way as to press and spread the resin composition 10. Thereby, the protruding portion 11c is absorbed, and a smooth laminate 30 can be obtained.

(Curing step)

The curing step is a step of curing the ultraviolet curable resin composition by irradiation with an ultraviolet ray from a side facing toward the base material. The irradiation conditions of an ultraviolet ray are not particularly limited, and the same conditions as those described above can be adopted.

(Grinding step)

The grinding step is a step of grinding a back surface 23 of the semiconductor wafer 20 opposite to the front surface 22 on which the protruding portion 21 is provided. In the grinding step, the back surface 23 of the semiconductor wafer 20 is ground with the laminate 30 of the adherend 11, the cured resin composition 10', and the base material 12 in close contact with the front surface 22 of the semiconductor wafer 20. The grinding conditions are not particularly limited, and conventionally known conditions can be applied.

After grinding, the laminate 30 is peeled off from the front surface 22 of the semiconductor wafer 20. The peeling of the laminate 30 is not particularly limited, and can be carried out, for example, by bending the laminate 30 in a direction in which the laminate 30 is separated from the semiconductor wafer. At this time, in the laminate using the resin composition 10 of the present embodiment, interlayer peeling between the adherend 11 or the base material 12 and the cured resin composition 10' is unlikely to occur, and the remaining thereof on the front surface 22 of the semiconductor wafer 20 can be suppressed.

Examples

Hereinafter, the present invention will be described more specifically with reference to Examples and Comparative Examples. The present invention is not limited by the following Examples at all.

<Example 1>

(Preparation of resin composition)

23.920% by weight in terms of solid content of a urethane acrylic oligomer ("UV3630ID80" manufactured by Mitsubishi Chemical Corporation, weight average molecular weight of 35000) as an oligomer having a polymerizable unsaturated double bond, 5.980% by weight of isodecyl acrylate ("IDAA" manufactured by Osaka Organic Chemical Industry Ltd.), 10.960% by weight of isobornyl acrylate ("IBXA" manufactured by Osaka Organic Chemical Industry Ltd.), 12.460% by weight of lauryl acrylate ("LA" manufactured by Osaka Organic Chemical Industry Ltd.), and 31.870% by weight of N,N-diethylacrylamide ("DEAA" manufactured by KJ Chemicals Corporation), each as a monomer having a polymerizable unsaturated double bond, 12.460% by weight of a terpene phenol resin ("YS POLYSTAR T145" manufactured by Yasuhara Chemical Co., Ltd.) as a tackifier, 0.050% by weight of citric acid ("Citric Acid Anhydrous" manufactured by ADM Japan, pKa1 = 3.1) as an acid, 2.000% by weight of 2,4,6-trimethylbenzoyl-diphenyl-phosphine oxide ("Omnirad TPO" manufactured by IGM Resins B.V.) as a photopolymerization initiator, and 0.300% by weight of phenothiazine ("Phenothiazine" manufactured by Tokyo Chemical Industry Co., Ltd.) as a polymerization inhibitor were added and kneaded by using a planetary stirrer ("Awatori Rentaro AR-310" manufactured by Thinky Corporation, rotation speed of 2000 rpm) to prepare an ultraviolet curable resin composition.

[Viscosity of resin composition]

The viscosity of the prepared resin composition was measured at 25°C by using an E-type viscometer.

[Adhesion force of cured product (initial)]

The resin composition immediately after being prepared as described above was applied onto an adherend (ionomer film) in a square having a side of 100 mm and to a thickness of 50 $\mu$m, and a base material (PET film) having an ultraviolet transmission property was placed thereon from above in such a way as not to insert an air bubble between the base material and the resin composition, and the workpiece was allowed to stand for 3 minutes. After that, the workpiece was irradiated from a side facing toward the base material with an ultraviolet ray having a wavelength of 365 nm at an irradiation intensity of 60 mW/cm$^2$ and an irradiation dose of 600 mJ/cm$^2$ by using an LED lamp to cure the resin composition to prepare a laminate for adhesion force measurement.

The prepared laminate was cut to a width of 20 mm, and peeled at an angle of 180 degrees from the adherend side at a speed of 300 mm/min in an environment of a temperature of 23°C and a relative humidity of 50% based on JIS Z 0237, and the peel strength at this time was taken as the adhesion force (initial). The obtained peel strength is the smaller value of the peel strength between the adherend and the cured product and the peel strength between the adherend and the base material.

(Evaluation criteria)

A (pass): Adhesion force (initial) of 15 N/20 mm or more
B (pass): Adhesion force (initial) of 6 N/20 mm or more and less than 15 N/20 mm
C (fail): Adhesion force (initial) of less than 6 N/20 mm

[Adhesion force of cured product (after storage for 130 days)]

The resin composition thus prepared was placed in a polyethylene light-resistant black container, the container was sealed and stored for 130 days in an environment of a temperature of 23°C and a relative humidity of 50%, and then the adhesion force (after storage) was measured under the same conditions as in the above adhesion force of cured product (initial). Based on the obtained adhesion force (after storage), the storage stability was evaluated according to the following evaluation criteria.

(Evaluation criteria)

A (pass): Adhesion force (after storage) of 15 N/20 mm or more
B (pass): Adhesion force (after storage) of 6 N/20 mm or more and less than 15 N/20 mm
C (fail): Adhesion force (after storage) of less than 6 N/20 mm

[Hardness]

A silicone sheet having a thickness of 2 mm, which was hollowed out into a square having a side of 25 mm, was placed on the release surface of a PET film, and the hollowed out portion of the silicone sheet was filled with the prepared resin composition. After that, another PET film was placed such that the release surface faced toward the resin composition side and no bubbles were inserted between the release surface and the resin composition. Next, a curing apparatus, manufactured by Fusion UV Systems, Inc., using an electrodeless discharge lamp was used to cure the resin composition for 160 seconds under a condition where the integrated light dose at a wavelength of 365 nm was 2000 mJ/cm$^2$, and the PET film and the silicone sheet were removed to prepare a test piece for hardness measurement having a thickness of 2 mm. The prepared test piece was measured for D hardness by using a D hardness tester in an environment of a temperature of 23°C and a relative humidity of 50% according to JIS K6253, and this value was taken as the hardness of the resin composition. In addition, the hardness was evaluated according to the following evaluation criteria based on the obtained hardness.

(Evaluation criteria)

A: Hardness of 15 or more and 60 or less
B: Hardness of less than 15 or more than 60

[Storage stability at 50°C in sealed stainless steel pipe]

A SUS304 tee pipe having a nominal diameter of 1/8 was filled with the prepared resin composition, screwed and sealed at all three locations with SUS304 closing screws having a nominal diameter of 1/8 wrapped with a PTFE tape, and then stored in an oven having a 50°C atmosphere, and the number of days required for gelation to occur was measured. Based on the obtained number of days, the storage stability was evaluated according to the following evaluation criteria.

(Evaluation criteria)

A (pass): 30 days or more required for gelation to occur
B (pass): 7 days or more and less than 30 days required for gelation to occur
C (fail): less than 7 days required for gelation to occur

<Example 2>

A resin composition was prepared in the same manner as in Example 1 except that in Example 1, the amount of N,N-diethylacrylamide was changed to 31.885% by weight and the acid was changed to oxalic acid (manufactured by FUJIFILM Wako Pure Chemical Corporation, pKa1 = 1.3) in an amount of 0.035% by weight.

<Example 3>

A resin composition was prepared in the same manner as in Example 1 except that in Example 1, the amount of N,N-diethylacrylamide was changed to 31.884% by weight and the acid was changed to formic acid (manufactured by FUJIFILM Wako Pure Chemical Corporation, pKa1 = 3.8) in an amount of 0.036% by weight.

<Example 4>

A resin composition was prepared in the same manner as in Example 1 except that in Example 1, the amount of the urethane acrylic oligomer was changed to 23.960% by weight, the amount of isodecyl acrylate was changed to 5.990% by weight, the amount of isobornyl acrylate was changed to 10.980% by weight, the amount of lauryl acrylate was changed to 12.480% by weight, the amount of N,N-diethylacrylamide was changed to 31.960% by weight, the amount of the terpene phenol resin was changed to 12.480% by weight, and the amount of phenothiazine was changed to 0.100% by weight.

<Example 5>

A resin composition was prepared in the same manner as in Example 1 except that in Example 1, the amount of the urethane acrylic oligomer was changed to 23.870% by weight, the amount of isodecyl acrylate was changed to 5.970% by weight, the amount of isobornyl acrylate was changed to 10.940% by weight, the amount of lauryl acrylate was changed to 12.430% by weight, the amount of N,N-diethylacrylamide was changed to 31.810% by weight, the amount of the terpene phenol resin was changed to 12.430% by weight, and the amount of phenothiazine was changed to 0.500% by weight.

<Example 6>

A resin composition was prepared in the same manner as in Example 1 except that in Example 1, the amount of the urethane acrylic oligomer was changed to 23.930% by weight, the amount of isobornyl acrylate was changed to 10.970% by weight, the amount of N,N-diethylacrylamide was changed to 31.890% by weight, and the amount of citric acid was changed to 0.010% by weight.

<Example 7>

A resin composition was prepared in the same manner as in Example 1 except that in Example 1, the amount of the urethane acrylic oligomer was changed to 23.810% by weight, the amount of isodecyl acrylate was changed to 5.950% by weight, the amount of isobornyl acrylate was changed to 10.910% by weight, the amount of lauryl acrylate was changed to 12.400% by weight, the amount of N,N-diethylacrylamide was changed to 31.734% by weight, the amount of the terpene phenol resin was changed to 12.400% by weight, and the amount of citric acid was changed to 0.496% by weight.

<Example 8>

A resin composition was prepared in the same manner as in Example 1 except that in Example 1, the amount of the urethane acrylic oligomer was changed to 23.980% by weight, the amount of isodecyl acrylate was changed to 5.990% by weight, the amount of isobornyl acrylate was changed to 10.990% by weight, the amount of lauryl acrylate was changed to 12.490% by weight, the amount of N,N-diethylacrylamide was changed to 31.970% by weight, the amount of the terpene phenol resin was changed to 12.490% by weight, and the amount of phenothiazine was changed to 0.040% by weight.

<Example 9>

A resin composition was prepared in the same manner as in Example 1 except that in Example 1, the amount of the urethane acrylic oligomer was changed to 23.750% by weight, the amount of isodecyl acrylate was changed to 5.940% by weight, the amount of isobornyl acrylate was changed to 10.890% by weight, the amount of lauryl acrylate was changed to 12.370% by weight, the amount of N,N-diethylacrylamide was changed to 31.630% by weight, the amount of the terpene phenol resin was changed to 12.370% by weight, and the amount of phenothiazine was changed to 1.000% by weight.

<Example 10>

A resin composition was prepared in the same manner as in Example 1 except that in Example 1, the amount of the urethane acrylic oligomer was changed to 23.930% by weight, the amount of isobornyl acrylate was changed to 10.970% by weight, the amount of N,N-diethylacrylamide was changed to 31.897% by weight, and the amount of citric acid was changed to 0.003% by weight.

<Example 11>

A resin composition was prepared in the same manner as in Example 1 except that in Example 1, the amount of the urethane acrylic oligomer was changed to 23.690% by weight, the amount of isodecyl acrylate was changed to 5.920% by weight, the amount of isobornyl acrylate was changed to 10.860% by weight, the amount of lauryl acrylate was changed to 12.340% by weight, the amount of N,N-diethylacrylamide was changed to 31.563% by weight, the amount of the terpene phenol resin was changed to 12.340% by weight, and the amount of citric acid was changed to 0.987% by weight.

<Comparative Example 1>

A resin composition was prepared in the same manner as in Example 1 except that in Example 1, the amount of the urethane acrylic oligomer was changed to 23.990% by weight, the amount of isodecyl acrylate was changed to 6.000% by weight, the amount of isobornyl acrylate was changed to 10.990% by weight, the amount of lauryl acrylate was changed to 12.490% by weight, the amount of N,N-diethylacrylamide was changed to 31.990% by weight, the amount of the terpene phenol resin was changed to 12.490% by weight, and phenothiazine was not blended.

<Comparative Example 2>

A resin composition was prepared in the same manner as in Example 1 except that in Example 1, the amount of the urethane acrylic oligomer was changed to 23.930% by weight, the amount of isobornyl acrylate was changed to 10.970% by weight, the amount of N,N-diethylacrylamide was changed to 31.900% by weight, and citric acid was not blended.

<Comparative Example 3>

A resin composition was prepared in the same manner as in Example 1 except that in Example 1, the amount of the urethane acrylic oligomer was changed to 23.910% by weight and the acid was changed to acrylic acid (manufactured by FUJIFILM Wako Pure Chemical Corporation, pKa1 = 4.4) in an amount of 0.060% by weight.

[Table 1]

| | | Examples | | | | | | | | | | | Comparative Examples | | |
|---|---|---|---|---|---|---|---|---|---|---|---|---|---|---|---|
| | | 1 | 2 | 3 | 4 | 5 | 6 | 7 | 8 | 9 | 10 | 11 | 1 | 2 | 3 |
| Urethane acrylate oligomer (UV-3630ID80) | [% by weight] | 23.920 | 23.920 | 23.920 | 23.960 | 23.870 | 23.930 | 23.810 | 23.980 | 23.750 | 23.930 | 23.690 | 23.990 | 23.930 | 23.910 |
| Acrylic monomer 1 (IDRA) ($\delta$=8.6) | [% by weight] | 5.980 | 5.980 | 5.980 | 5.990 | 5.970 | 5.980 | 5.950 | 5.990 | 5.940 | 5.980 | 5.920 | 6.000 | 5.980 | 5.980 |
| Acrylic monomer 2 (IBXA) ($\delta$=9.0) | [% by weight] | 10.960 | 10.960 | 10.960 | 10.980 | 10.940 | 10.970 | 10.910 | 10.990 | 10.890 | 10.970 | 10.860 | 10.990 | 10.970 | 10.960 |
| Acrylic monomer 3 (LA) ($\delta$=8.7) | [% by weight] | 12.460 | 12.460 | 12.460 | 12.480 | 12.430 | 12.460 | 12.400 | 12.490 | 12.370 | 12.460 | 12.340 | 12.490 | 12.460 | 12.460 |
| Acrylic monomer 4 (DEAA) ($\delta$=10.1) | [% by weight] | 31.870 | 31.885 | 31.884 | 31.960 | 31.810 | 31.890 | 31.734 | 31.970 | 31.630 | 31.897 | 31.563 | 31.990 | 31.900 | 31.870 |
| Tackifier (YS POLYSTER T145) | [% by weight] | 12.460 | 12.460 | 12.460 | 12.480 | 12.430 | 12.460 | 12.400 | 12.490 | 12.370 | 12.460 | 12.340 | 12.490 | 12.460 | 12.460 |
| Citric acid (pKa1=3.1) | [% by weight] | 0.050 | - | - | 0.050 | 0.050 | 0.010 | 0.496 | 0.050 | 0.050 | 0.003 | 0.987 | 0.050 | - | - |
| Oxalic acid (pKa1=1.3) | [% by weight] | - | 0.035 | - | - | - | - | - | - | - | - | - | - | - | - |
| Formic acid (pKa1=3.8) | [% by weight] | - | - | 0.036 | - | - | - | - | - | - | - | - | - | - | - |
| Acrylic acid (pKa1=4.4) | [% by weight] | - | - | - | - | - | - | - | - | - | - | - | - | - | 0.060 |
| Polymerization inhibitor (phenothiazine) ($\delta$=12.3) | [% by weight] | 0.300 | 0.300 | 0.300 | 0.100 | 0.500 | 0.300 | 0.300 | 0.040 | 1000 | 0.300 | 0.300 | - | 0.300 | 0.300 |
| Photopolymerization initiator (Omnirad TPO) | [% by weight] | 2.000 | 2.000 | 2.000 | 2.000 | 2000 | 2.000 | 2.000 | 2.000 | 2.000 | 2.000 | 2.000 | 2.000 | 2.000 | 2.000 |

EP 4 269 103 A1

16

(continued)

| | | Examples | | | | | | | | | | | Comparative Examples | | |
|---|---|---|---|---|---|---|---|---|---|---|---|---|---|---|---|
| | | 1 | 2 | 3 | 4 | 5 | 6 | 7 | 8 | 9 | 10 | 11 | 1 | 2 | 3 |
| SP value of all of monomer | $\delta[(cal/cm3)^{1/2}]$ | 9.7 | 9.7 | 9.7 | 9.7 | 9.7 | 9.7 | 9.7 | 9.7 | 9.7 | 9.7 | 9.7 | 9.7 | 9.7 | 9.7 |
| 25°C viscosity of resin composition | [mPa·s] | 358 | 352 | 352 | 352 | 358.4 | 358 | 396.8 | 346 | 371.2 | 332 | 448 | 346 | 346 | 352 |
| Adhesion force of cured product (initial) | [N/20mm] | 25.5 | 27.9 | 19.6 | 24.8 | 18.8 | 12.0 | 23.6 | 21.8 | 16.4 | 7.4 | 13.7 | 28.0 | 1.3 | 1.7 |
| | Evaluation | A | A | A | A | A | B | A | A | A | B | B | A | C | C |
| Adhesion force of cured product (after storage) | [N/20mm] | 23.4 | 14.8 | 9.6 | 22.6 | 18.2 | 8.4 | 23.3 | 20.9 | 14.4 | 6.3 | 13.6 | 25.8 | 1.3 | 1.5 |
| | Evaluation | A | A | B | A | A | B | A | A | B | B | B | A | C | C |
| Storage stability at 50°C in sealed stainless steel pipe | [days] | >30 | >30 | >30 | 14 | >30 | >30 | >30 | 9 | >30 | >30 | >30 | 4 | >30 | >30 |
| | Evaluation | A | A | A | B | A | A | A | B | A | A | A | C | A | A |
| D Hardness of cured product | | 22.5 | 20.7 | 21.3 | 22.8 | 19.4 | 20.0 | 21.1 | 24.6 | 15.3 | 23.0 | 21.8 | 21.5 | 22.7 | 24.0 |
| | Evaluation | A | A | A | A | A | A | A | A | A | A | A | A | A | A |

EP 4 269 103 A1

Industrial Applicability

The ultraviolet curable resin composition of the present invention has excellent storage stability, is sufficiently cured even with a low UV irradiation dose, and exhibits sufficient adhesion force to a base material or an adherend. Because of this, the ultraviolet curable resin composition and a cured product or a laminate using the ultraviolet curable resin composition can be applied to many applications carrying out interlayer adhesion using an ultraviolet ray, such as a roughness absorbing layer of a semiconductor backgrinding tape.

Reference Signs List

10 ... resin composition, 10' ... cured resin composition, 11 ... adherend, 11a ... surface, 11b ... surface, 11c ... protruding portion, 12 ... base material, 20 ... semiconductor wafer, 21 ... protruding portion, 22 ... front surface, 23 ... back surface, 30 ... laminate.

**Claims**

1. An ultraviolet curable resin composition comprising:

   a monomer and/or an oligomer having a polymerizable unsaturated double bond;
   a photopolymerization initiator;
   a polymerization inhibitor; and
   an acid having an acid dissociation constant (pKa1) in pure water of 4.0 or less.

2. The ultraviolet curable resin composition according to claim 1, wherein
   an absolute value difference between a solubility parameter of the polymerization inhibitor and a solubility parameter of all of the monomer in the resin composition is 4.0 $(cal/cm^3)^{1/2}$ or less.

3. The ultraviolet curable resin composition according to claim 1 or 2, wherein
   a content of the polymerization inhibitor is 0.02 to 2.0% by weight based on the total weight of the ultraviolet curable resin composition.

4. The ultraviolet curable resin composition according to any one of claims 1 to 3, wherein
   a content of the acid is 0.005 to 2.0% by weight based on the total weight of the ultraviolet curable resin composition.

5. The ultraviolet curable resin composition according to any one of claims 1 to 4, wherein
   the polymerization inhibitor comprises an amine-based polymerization inhibitor.

6. The ultraviolet curable resin composition according to any one of claims 1 to 5, wherein
   the photopolymerization initiator comprises a radical generating photopolymerization initiator and/or an anion generating photopolymerization initiator.

7. The ultraviolet curable resin composition according to any one of claims 1 to 6, wherein
   the oligomer comprises a urethane acrylate oligomer.

8. The ultraviolet curable resin composition according to any one of claims 1 to 7, wherein
   the monomer comprises a monofunctional acrylamide.

9. The ultraviolet curable resin composition according to claim 8, wherein
   a surface tension of the monofunctional acrylamide is 30 to 38 mN/m.

10. The ultraviolet curable resin composition according to any one of claims 1 to 9, wherein a viscosity thereof at 25°C is 200 to 10000 mPa·s.

11. A cured product obtained by curing the ultraviolet curable resin composition according to any one of claims 1 to 10 with an ultraviolet ray.

12. A laminate obtained by adhering a base material having an ultraviolet transmission property and an adherend with the ultraviolet curable resin composition according to any one of claims 1 to 10 therebetween by curing thereof.

13. The laminate according to claim 12, wherein
the laminate is for use in a semiconductor processing application.

14. A method for producing a semiconductor wafer, comprising:

an affixing step of affixing an adherend to a surface of a semiconductor wafer on which a protruding portion is provided;
a lamination step of laminating the adherend and a base material having an ultraviolet transmission property with the ultraviolet curable resin composition according to any one of claims 1 to 10 therebetween;
a curing step of curing the ultraviolet curable resin composition by irradiation with an ultraviolet ray from a side facing toward the base material; and
a grinding step of grinding a surface of the semiconductor wafer opposite to the surface on which the protruding portion is provided.

Figure 1

### Contacting Step

20           23

22           21

11a           11

11b

### Lamination step

20           23           11

22           21           11c

10           12

### Curing step

20

11
10'  } 30
12

### Grinding step

20

11
10'  } 30
12

<div align="center">

### INTERNATIONAL SEARCH REPORT

</div>

| | International application No. |
|---|---|
| | **PCT/JP2021/041725** |

**A. CLASSIFICATION OF SUBJECT MATTER**

*B32B 27/30*(2006.01)i; *C08F 290/00*(2006.01)i; *C09J 4/02*(2006.01)i; *C09J 11/06*(2006.01)i; *C09J 175/14*(2006.01)i; *C08F 2/38*(2006.01)i; *C08F 2/44*(2006.01)i; *C08F 2/50*(2006.01)i; *H01L 21/304*(2006.01)i; *C09J 7/22*(2018.01)i; *C09J 7/38*(2018.01)i
FI: C08F290/00; C08F2/44 B; C08F2/50; C08F2/38; C09J7/22; C09J7/38; C09J4/02; C09J11/06; C09J175/14; B32B27/30 A; H01L21/304 631

According to International Patent Classification (IPC) or to both national classification and IPC

**B. FIELDS SEARCHED**

Minimum documentation searched (classification system followed by classification symbols)

B32B27/30; C08F290/00; C09J4/02; C09J11/06; C09J175/14; C08F2/38; C08F2/44; C08F2/50; H01L21/304; C09J7/22; C09J7/38

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2006-001863 A (NEW JAPAN CHEMICAL CO., LTD.) 05 January 2006 (2006-01-05) claims, paragraphs [0008], [0019], [0049], [0056], [0066], [0071]-[0073], [0081]-[0084], [0089], [0102]-[0122], table 3 | 1-12 |
| X | JP 2015-209390 A (SAKURA COLOR PRODUCTS CO.) 24 November 2015 (2015-11-24) claims, paragraphs [0010]-[0019], examples, table 1 | 1-11 |
| X | JP 57-202315 A (THE DOW CHEMICAL CO.) 11 December 1982 (1982-12-11) claims, p. 2, upper left column, lines 2-10, p. 2, lower right column, line 16 to p. 3, upper right column, line 10, examples | 1-12 |
| A | WO 2015/033801 A1 (TOAGOSEI CO., LTD.) 12 March 2015 (2015-03-12) entire text | 1-14 |

☐ Further documents are listed in the continuation of Box C.   ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 January 2022** | **01 February 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2021/041725**

| Patent document cited in search report | | | Publication date (day/month/year) | Patent family member(s) | | | Publication date (day/month/year) |
|---|---|---|---|---|---|---|---|
| JP | 2006-001863 | A | 05 January 2006 | (Family: none) | | | |
| JP | 2015-209390 | A | 24 November 2015 | CN | 106170279 | A | |
| JP | 57-202315 | A | 11 December 1982 | US | 4407991 | A | |
| | | | | claims, column 1, lines 33-41, column 3, lines 18-49, examples | | | |
| | | | | EP | 65735 | A1 | |
| WO | 2015/033801 | A1 | 12 March 2015 | US | 2016/0208051 | A1 | |
| | | | | entire text | | | |
| | | | | EP | 3042933 | A1 | |
| | | | | CN | 105593307 | A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019065168 A

- JP 2019065165 A

**Non-patent literature cited in the description**

- **R.F. FEDORS.** Polymer Engineering & Science. Wiley Publishing, 1974, vol. 14, 147-154

- Handbook of Chemistry. Maruzen Publishing Co., Ltd